Europäisches Patentamt

European Patent Office

Office européen des brevets

(19)

(11) Numéro de publication : **0 089 873**
**B1**

(12) **FASCICULE DE BREVET EUROPÉEN**

(45) Date de publication du fascicule du brevet :
**22.10.86**

(21) Numéro de dépôt : **83400503.5**

(22) Date de dépôt : **11.03.83**

(51) Int. Cl.⁴ : **G 01 R 31/28, H 04 N 17/00**

(54) **Dispositif et appareil de test d'équipements électroniques, notamment de télévision.**

(30) Priorité : **19.03.82 FR 8204754**

(43) Date de publication de la demande :
**28.09.83 Bulletin 83/39**

(45) Mention de la délivrance du brevet :
**22.10.86 Bulletin 86/43**

(84) Etats contractants désignés :
**DE GB**

(56) Documents cités :
**EP-A- 0 036 354**
**DE-A- 2 821 024**
**US-A- 4 240 100**
**JEE, JOURNAL OF ELECTRONIC ENGINEERING, vol. 18, no. 171, Mars 1981, pages 91-94, Tokyo, JP; T.IKENAGA: "TV measuring instruments making transition to digital methods"**

(73) Titulaire : **THOMSON-CSF**
**173, Boulevard Haussmann**
**F-75379 Paris Cedex 08 (FR)**

(72) Inventeur : **Pham Van Cang, Luc**
**THOMSON-CSF SCPI 173, bld Haussmann**
**F-75379 Paris Cedex 08 (FR)**

(74) Mandataire : **Lincot, Georges et al**
**THOMSON-CSF SCPI 19, avenue de Messine**
**F-75008 Paris (FR)**

**0 089 873**

## Description

La présente invention concerne un appareil de test d'équipements électroniques notamment de télévision.

La caractérisation ou la mesure de signaux sur des équipements électroniques soumis à des tests par des sollicitations électriques extérieures est conventionnellement effectuée à l'aide d'appareils de mesure tels que des voltmètres, des oscilloscopes, des fréquencemètres, des distorsiomètres.

Pour certains équipements électroniques très spécifiques comme le sont par exemple les équipements de télévision, les moyens habituels de mesure des grandeurs électriques ou électroniques doivent être complétés par des appareils de mesure directement adaptés à la saisie des signaux générés par ces équipements. C'est ainsi que pour les besoins de la télévision en couleur, les concepteurs ont été conduits à créer de nouveaux appareils de mesure tels que des vectorscopes, des mesureurs de bruit, des mesureurs des temps de transit, etc., ainsi que des dispositifs générateurs de signaux de test et d'essai permettant d'effectuer ces mesures. Ces générateurs sont par exemple des générateurs de signaux pour caractériser des transitoires, des générateurs de signaux pour caractériser les réponses amplitude-fréquence ou phase-fréquence, des générateurs de bruits, ou des générateurs de mire couleur du type par exemple décrit dans l'article de la revue « Journal of Electronic Engineering » Vol. 18, March 1981, No. 1, Tokyo Japan.

Ceci malheureusement conduit à une augmentation notable du coût des appareillages de test mis en œuvre qui va croissant avec la complexité de l'équipement à tester et à une complication des manipulations qu'il faut effectuer pour mener à bien les opérations de test correspondantes.

Le but de l'invention est de pallier les inconvénients précités à l'aide d'un dispositif de test qui soit à même de réaliser à lui seul l'ensemble des mesures électriques requises pour caractériser les signaux de l'appareil testé en étant plus souple d'utilisation que les dispositifs de l'art antérieur et suffisamment universel pour pouvoir être adapté sans modifications structurelles importantes à la mesure et au test d'un nombre pratiquement illimité d'équipements électroniques.

A cet effet l'invention a pour objet un dispositif de test d'équipements électroniques comprenant un dispositif de génération de signaux analogiques de test à destination de l'équipement à tester comprenant un calculateur numérique, couplé à un dispositif de conversion numérique analogique et à des moyens de mémorisation de signaux de test sous la forme d'échantillons numériques, un dispositif de saisie des signaux fournis par l'équipement électronique testé en réponse aux signaux de test reçus par l'équipement, ainsi que des moyens de visualisation commandés par le calculateur pour visualiser les signaux transmis par le dispositif de génération de signaux de test et/ou les signaux reçus par le dispositif de saisie, le calculateur numérique comprenant des moyens de création de signaux de test sous la forme d'échantillons numériques ainsi que des moyens pour transférer les échantillons mémorisés à l'intérieur des moyens de mémorisation et les échantillons créés par les moyens de création à destination du dispositif de conversion numérique-analogique, caractérisé en ce que, les moyens de création des signaux de test sous la forme d'échantillons sont constitués par une unité de traitement microprogrammée, couplés respectivement à des moyens de mémorisation de descripteurs de signaux de test, à des moyens de mémorisation de séquences d'instructions de programme, à des moyens de mémorisation de données pour l'obtention des échantillons pour permettre l'adressage aux moyens de mémorisation des descripteurs de signaux de test et à un clavier et en ce que les moyens de mémorisation des descripteurs de signaux de test comprennent pour chaque descripteur une zone indiquant le type du descripteur, une zone de mémorisation de l'adresse de début de la séquence d'instructions pour l'obtention des échantillons correspondant à ce descripteur, des zones d'adresses de zone de travail pour le rangement des paramètres relatifs au signal dans les moyens de mémorisation de données et une zone d'adresse pour identifier le début d'une zone de rangement des échantillons dans les moyens de mémorisation de données.

Grâce à cette disposition toutes les ressources nécessaires pour créer un signal de test sont identifiables à l'aide de descripteurs de signaux qui peuvent être adressés directement à l'aide du clavier relié à l'unité de traitement. Comme chaque descripteur contient en particulier l'adresse de début d'un programme de génération d'un signal de test élémentaire, l'opérateur peut, directement à partir, par exemple, du clavier ou de tout autre moyen d'accès, lancer les programmes qui correspondent au type de signal de test qu'il souhaite obtenir.

Cette disposition est particulièrement avantageuse, car elle autorise la création d'une multitude de signaux de test composés chacun de l'association de plusieurs signaux élémentaires pouvant être créés successivement dans le temps. Cette réaction a lieu directement par une sélection de l'opérateur des différents descripteurs dont il a besoin pour composer le signal de test.

Un autre avantage du dispositif selon l'invention est qu'il permet chaque fois qu'un nouveau signal de test est créé, d'enrichir la bibliothèque des signaux de test déjà contenus dans les moyens de mémorisation, puisque cette dernière opération s'exécute par un simple transfert des échantillons créés de l'unité de traitement vers les moyens de mémorisation.

Encore un autre avantage du dispositif selon l'invention est qu'il permet un échantillonnage précis de chaque signal saisi qui dans le cas d'une saisie de signaux de télévision se traduit par une analyse fine du

2

point de l'image de télévision qui est sélectionné. Cette analyse est faite sélectivement en désignant l'adresse du signal, ou du point dans l'image transmise à l'aide du clavier relié à l'unité de traitement, et les informations caractérisant le signal ou le point désigné sont lues une ou plusieurs fois par le calculateur qui ainsi a tout son temps pour traiter les informations relatives au signal ou au point dont l'analyse est demandée.

D'autres caractéristiques et avantages de l'invention apparaîtront au cours de la description faite au regard des dessins annexés, donnés uniquement à titre d'exemple d'un dispositif de test d'équipements électroniques conçu plus particulièrement pour le test d'équipements émetteur ou récepteur de télévision en couleur et dans lesquels :

La figure 1 est une représentation du dispositif de test d'équipements électroniques selon l'invention.

La figure 2 est une représentation sous forme synoptique du dispositif de génération de signaux analogiques de test de télévision suivant l'invention.

La figure 3 est une représentation d'un descripteur de signal.

La figure 4 est une représentation des mémoires mortes comportant des moyens de mémorisation, et de leurs circuits associés.

La figure 5 est une représentation des circuits d'adressage et de l'organisation de la mémoire à lecture-écriture.

La figure 6 est une représentation des moyens de synchronisation.

La figure 7 est une représentation sous forme synoptique du dispositif de saisie de signaux de télévision selon l'invention.

La figure 8 est une représentation détaillée des éléments constituant le dispositif de la figure 7.

La figure 9 montre un exemple de réalisation du réseau de traitement est de mise en format du signal de la figure 8.

La figure 10 représente le décodeur des signaux de commande de la figure 8.

La figure 11 est une représentation de la logique de commande de la figure 8.

La figure 12 est un organigramme représentant le fonctionnement général du dispositif.

La figure 13 est un organigramme d'organisation d'un sous-programme pour le calcul d'un signal élémentaire.

La figure 14 représente une forme possible d'un signal généré par le dispositif de génération de signaux analogiques de test.

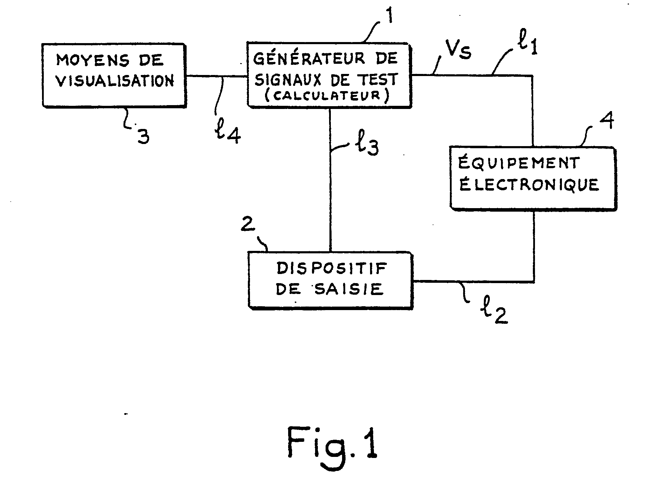

Le dispositif représenté à la figure 1 comprend un générateur de signaux analogiques de test 1 composé d'un calculateur, un dispositif de saisie 2 et des moyens de visualisation 3. L'équipement de télévision à tester 4 est couplé d'une part, par une ligne $l_1$, à une sortie du générateur de signaux 1 et d'autre part, par une ligne $l_2$, au dispositif de saisie 2 pour fournir à ce dernier les signaux de télévision obtenus en réponse aux signaux de sollicitation délivrés par le générateur 1. Une ligne $l_3$ assure un transfert d'informations entre le générateur 1 et le dispositif de saisie 2. Le générateur 1 est couplé aux moyens de visualisation 3 par une ligne $l_4$.

La conformation des signaux de télévision dont il s'agit ici n'a pas besoin d'être décrite pour la compréhension de l'invention, on indique toutefois que ces signaux sont ceux définis par les normes internationales actuellement en vigueur, une définition de ces signaux pourra être trouvée dans le livre intitulé « Radiotechnique et Télévision » pages 186 à 190 de Bogdan Grabowski édité par la Société DUNOD (Paris) dans la collection aide-mémoire.

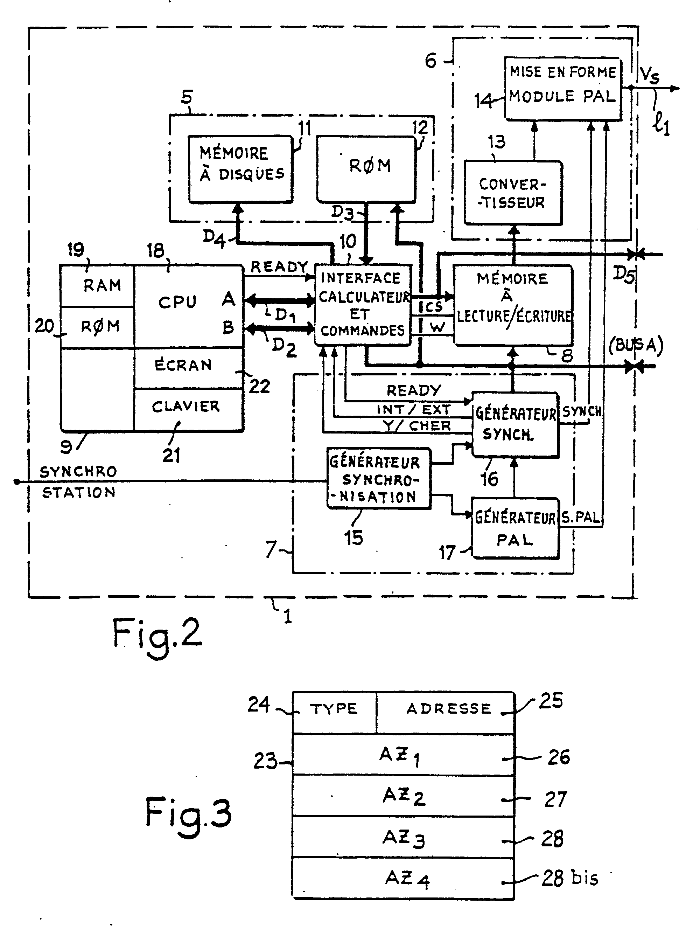

Le dispositif de génération de signaux analogiques de test est représenté à la figure 2, il comprend des moyens de mémorisation 5, un convertisseur numérique-analogique 6, des moyens de synchronisation 7, une mémoire à lecture-écriture 8 et un calculateur 9. Une interface 10 assure les liaisons entre les moyens de mémorisation 5 et la mémoire à lecture-écriture 8, cette interface est commandée par le calculateur 9. Le calculateur 9 est relié par ses portes A et B à l'interface 10 au moyen, respectivement, de la ligne de données $D_1$ et de la ligne de commande de destination des données $D_2$. Les données transitent entre les moyens de mémorisation 5 et l'interface 10 au moyen des lignes de données $D_3$ et $D_4$. Ces données ressortent de l'interface 10 à destination de la mémoire lecture-écriture 8 et à destination du dispositif de saisie 2 au moyen de la ligne de données $D_5$. La ligne de données $D_5$ est bidirectionnelle, c'est-à-dire qu'elle peut également transmettre des données provenant du dispositif de saisie 2 ou de la mémoire à lecture-écriture 8 à destination de l'interface 10. La ligne $D_5$ est reliée au dispositif de saisie au moyen de la ligne $l_3$ de la figure 1.

Les moyens de mémorisation 5 comprennent une mémoire de masse 11 et une mémoire morte 12. La mémoire de masse 11 est une mémoire à très grande capacité qui renferme la bibliothèque des signaux de test du dispositif, elle peut être constituée par une mémoire à disque ou une disquette. Le transfert des signaux entre la mémoire de masse 11 et l'interface 10 a lieu sur la ligne de données $D_4$ sous la commande du calculateur 9. La mémoire morte 12 contient un jeu de signaux de test pré-programmés. Ce jeu de signaux peut être en nombre très réduit et peut être constitué par ceux des signaux les plus couramment utilisés pour tester les appareils de télévision et permettre des tests rapides sans mettre en œuvre la bibliothèque des signaux de test contenus dans la mémoire de masse 11.

Le convertisseur analogique-numérique 6 comprend un convertisseur 13 dont les entrées reçoivent le signal numérique lu dans la mémoire 8 et dont la sortie délivre un signal analogique à destination d'un

**0 089 873**

étage de mise en forme de signaux 14, dont la sortie délivre un signal analogique $V_S$ sur la ligne $I_1$ reliant le générateur 1 à l'équipement électronique testé 4.

Les moyens de synchronisation 7 sont constitués par un générateur de synchronisation 15, un dispositif 16 de génération de signaux de synchronisation SYNCH et d'un dispositif 17 de génération des signaux de synchronisation PAL à destination de l'étage de mise en forme 14.

La mémoire à lecture-écriture 8 est constituée par une mémoire vive du type RAM qui est une abréviation du terme anglo-saxon « random access memory ».

La mémoire à lecture-écriture 8 ainsi que la mémoire morte 12 sont adressées par un bus d'adresses commun BUSA sur lequel transitent des adresses provenant du système de synchronisation 7 ou du calculateur 9 par l'intermédiaire de l'interface 10. Le bus d'adresse BUSA est également relié au dispositif de saisie au moyen de la ligne $I_3$ pour permettre au calculateur 9 de transmettre au dispositif de saisie les adresses des échantillons qu'il désire saisir.

Le calculateur 9 a une structure de microordinateur et à ce titre est constitué, d'une façon connue par une unité centrale de traitement CPU 18, constituée par exemple par un microprocesseur, interconnecté sur ses bus de données et d'adresse à une mémoire centrale RAM 19 et à au moins une mémoire morte ROM 20. Pour plus de détails sur la réalisation des microordinateurs on pourra se reporter au livre intitulé « Microprocesseurs et microordinateurs » de R. LYON CAEN et J.M. CROZET édité chez Masson Paris 1977 ou au livre intitulé « Minicomputers systems » de Cay WEITZMAN édité par Prentice Hall Inc. New York 1974. La mémoire ROM 20 contient l'ensemble des tables et des microprogrammes nécessaires pour exécuter les transferts d'informations ou de données entre les moyens de mémorisation 5 et la mémoire à lecture-écriture 9 ainsi que ceux qui sont nécessaires pour la création des nouveaux signaux de test. Le contrôle et la commande de ces transferts sont assurés par l'exécution d'instructions d'entrée-sortie dont la mise en œuvre est généralement indiquée dans les spécifications techniques des microprocesseurs actuellement commercialisés et qui par conséquent n'ont pas besoin d'être décrits pour la compréhension de l'invention. Les tables utilisées pour la génération des signaux de test sont constituées par des zones de mémoire ROM 20 contenant les descripteurs de signaux.

Le format d'un descripteur de signal est représenté à la figure 3. Sur cette figure, le descripteur 23 est constitué par les zones 24 à 28 bis. La zone 24 mémorise le type du descripteur et permet de reconnaître le descripteur lorsqu'il est sélectionné au clavier par l'opérateur. La zone 25 contient l'adresse de début du programme de génération de signaux de test correspondant au descripteur, ce programme est mémorisé à l'intérieur de la mémoire ROM 20. La zone 26 spécifie l'adresse $AZ_1$ d'une zone de la mémoire centrale 19 dans laquelle est rangée l'amplitude du premier échantillon du signal correspondant au descripteur et à partir de laquelle sont rangés les échantillons suivants du signal. La zone 27 spécifie l'adresse $AZ_2$ d'une zone de la mémoire centrale 19 dans laquelle est rangée l'instant de début du signal. La zone 28 spécifie l'adresse $AZ_3$ d'une zone de la mémoire centrale 19 dans laquelle est rangée l'amplitude de la fin du signal. La zone 28 bis spécifie l'adresse $AZ_4$ d'une zone de la mémoire centrale 19 dans laquelle est rangée l'instant marquant la fin du signal. Les zones d'adresse $AZ_1$ à $AZ_4$ de la mémoire centrale sont écrites à partir du clavier 21 une fois que l'opérateur a sélectionné le descripteur.

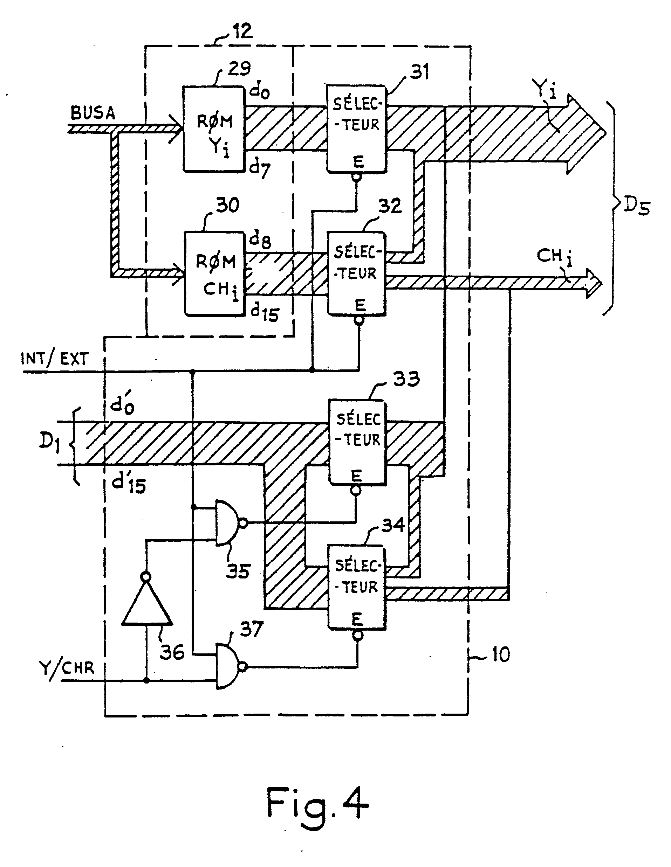

Les liaisons de la mémoire morte 12 ainsi que les liaisons du calculateur 9 avec la mémoire à lecture-écriture 8 sont représentées à la figure 4. Sur cette figure, la mémoire morte 12 est constituée par deux blocs de mémoire 29 et 30. La mémoire 29 contient des échantillons $Y_i$ des signaux de luminance et la mémoire 30 contient des échantillons $CH_i$ des signaux de chrominance. Un plan de constitution de ces mémoires pourra être réalisé, par exemple, à l'aide de deux mémoires mortes de 32 K bits chacune du type n° 2732 commercialisé par la société MOTOROLA ce qui correspond à une capacité de 4 K mots de 16 bits qui peut ainsi recueillir 2 signaux de test à 2 048 échantillons chacun. Selon cette organisation, un mot de seize bits, lu dans la mémoire 12, est placé sur les sorties d0 à d15 de la mémoire 12, les sorties d0 à d9 transmettant les bits de luminance, les sorties d10 à d13 transmettant les bits de chrominance et la sortie d15 transmettant un bit de contrôle. Les sorties d0 à d7 de la mémoire 29 sont reliées aux entrées respectives d'un sélecteur 31 et les sorties d8 à d15 de la mémoire 30 sont reliées aux entrées respectives d'un sélecteur 32. Les sélecteurs 31 et 32 transmettent respectivement les bits des échantillons $Y_i$ de luminance apparaissant sur les sorties d0 à d7 et les bits des échantillons $CH_i$ de chrominance apparaissant sur les sorties d8 à d13 des mémoires 29 et 30, sur la ligne de données $D_5$, lorsqu'ils sont commandés sur leur entrée E.

Les données $d'_0$ à $d'_{15}$ provenant du calculateur sur la ligne de données $D_1$ sont appliquées aux entrées respectives des sélecteurs 33 et 34. Ces données sont transmises par les sorties des sélecteurs 33 et 34 à destination de la ligne de données $D_5$ lorsque les entrées E des sélecteurs 33 et 34 sont validées. La validation des entrées E des sélecteurs 33 à 34 est effectuée de la façon suivante. Les sélecteurs 31 et 32 sont commandés lorsque le dispositif est synchronisé par des signaux d'horloge externes provenant par exemple d'une station d'émission de télévision. Les sélecteurs 33 et 34 sont commandés lorsque le dispositif n'est pas relié à une station et qu'il fonctionne en mode interne sur une horloge interne. L'entrée E du sélecteur 33 est reliée à la sortie de la porte NON ET 35 à deux entrées, une entrée recevant un signal de commande interne-externe INT/EXT provenant des moyens de synchronisation 7 et l'autre entrée est reliée à la sortie de l'amplificateur inverseur 36 qui reçoit sur une entrée un signal Y/CHR provenant également des moyens de synchronisation 7. L'entrée E du sélecteur 34 est reliée à la sortie de la porte NON ET 37 à deux entrées, une entrée recevant le signal interne-externe et dont l'autre entrée

4

**0 089 873**

reçoit le signal .Y-CHR. Le signal Y-CHR commande lorsqu'il est dans un premier état, la sélection par le sélecteur 33 des échantillons $Y_i$ des signaux de luminance placés sur les lignes $d'_0$ à $d'_7$ de la ligne de donnée $D_1$ et commande lorsqu'il est dans un deuxième état, la sélection par le sélecteur 34, des échantilons $CH_i$ des signaux de chrominance placés sur les lignes $d'_8$ à $d'_{13}$ de la ligne de donnée $D_1$.

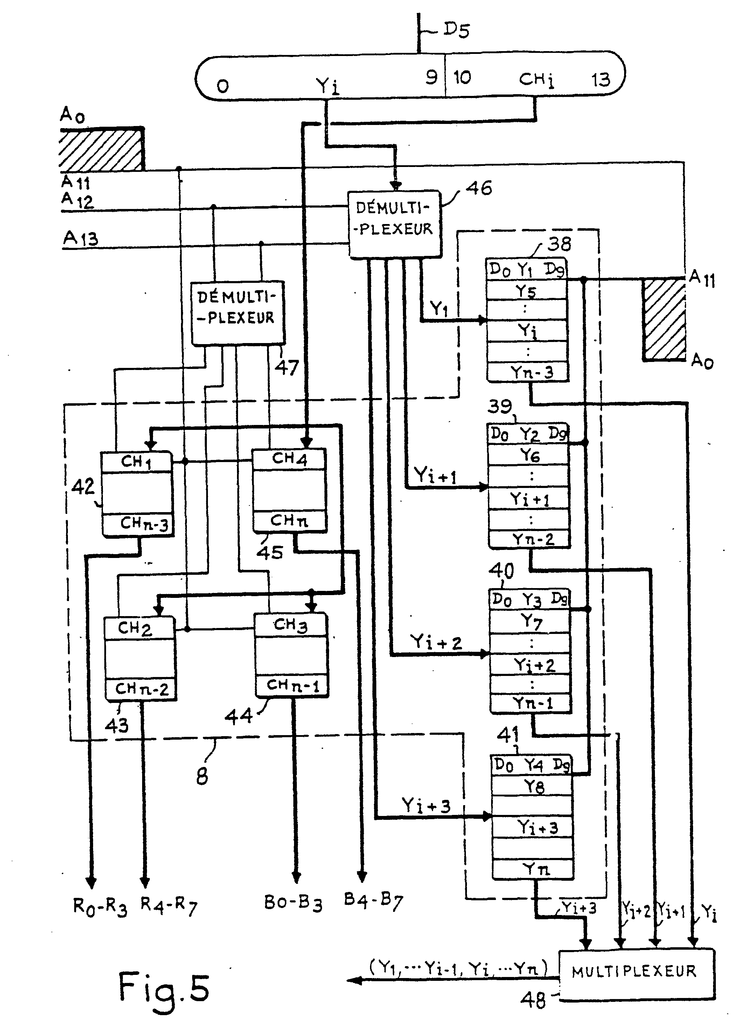

Un exemple d'organisation de la mémoire à lecture-écriture 8 est représenté à la figure 5. La mémoire 8 est constituée de circuits de mémoires rapides par exemple de circuits statiques CMOS dont le temps de cycle est d'environ 100 nano-secondes. Pour permettre leur fonctionnement à la fréquence de 32 MHz qui correspond à la transmission de 2 048 échantillons par ligne de télévision, ces circuits sont démultiplexés à l'écriture et multiplexés à la lecture par quatre afin de rendre transparent le multiplexage à l'utilisateur.

Dans un exemple de réalisation possible, des circuits de 4 K bits peuvent être utilisés, ce qui, compte tenu du multiplexage par quatre, permet de garder un jeu complet de huit signaux de test dans chaque circuit. Dans ce cas quarante circuits sont nécessaires pour la mémorisation des échantillons de luminance codés sur dix bits, et seize circuits sont nécessaires pour la mémorisation des deux échantillons de chrominance. Dans l'exemple de la figure 5, la mémoire 8 contient quatre blocs de mémoires 38 à 41 pour la mémorisation des signaux de luminance Y1 à YN et quatre blocs de mémoire 42 à 45 pour la mémorisation des signaux de chrominances CHI à CHN. Les mémoires 38 à 41 sont partagées en mots de dix bits représentant chacun un échantillon de luminance, les mémoires 42 à 45 sont partagées en mots de quatre bits représentant chacun un échantillon de chrominance. Chaque mot de dix bits ou de quatre bits contenu dans une des mémoires 38 à 45 est adressé par les fils A0 à A11 du bus d'adresses BUSA. Les mots de luminance d0 à d9 et ceux de chrominance d10 à d13 qui sont transmis sur le bus $D_5$ sont appliqués respectivement d'une part, à l'entrée d'un démultiplexeur 46 et d'autre part à l'entrée d'un démultiplexeur 47. Le démultiplexeur 46 aiguille la suite Y1 à YN des mots de luminance, constitués des bits d0 à d9, successivement dans l'un des quatre blocs de mémoire 38 à 41, de façon que la mémoire 38 contienne les mots Y1, Y5 ... Yi Yi + 4 ... YN-3, la mémoire 39 contienne les mots Y2, Y6 ... Yi + 1, Yi + 5, YN — 2, la mémoire 40 contienne les mots Y3, Y7 ... Yi + 2 Yi + 6 ... YN — 1 et la mémoire 41 contienne les mots Y4, Y8, ... Yi + 3, Yi + 7 ... YN. Le démultiplexeur 47 aiguille les mots de chrominance CH (d10 à d13) dans l'un des quatre blocs de mémoire 42 à 45, cycliquement en commençant par les mémoires 42 et en terminant par la mémoire 45.

La commande d'aiguillage des données, dans chacun des blocs 38 à 41 d'une part et 42 à 45 d'autre part, est assurée par les fils d'adresses A12, A13 du bus d'adresses BUSA qui sont reliées sur les entrées de commande des démultiplexeurs 46 et 47. Les mots de luminance sont lus au travers du multiplexeur 48 qui délivre sur sa sortie les mots de luminance YI à YN en direction du convertisseur 13, lorsqu'ils sont successivement lus dans les blocs de mémoires 38 à 41. Les mots de chrominance qui sont lus dans les blocs 42 à 45 sont appliqués respectivement sur les lignes R0-R3, R4-R7 et B0-B3, B4-B7 à destination du convertisseur 13.

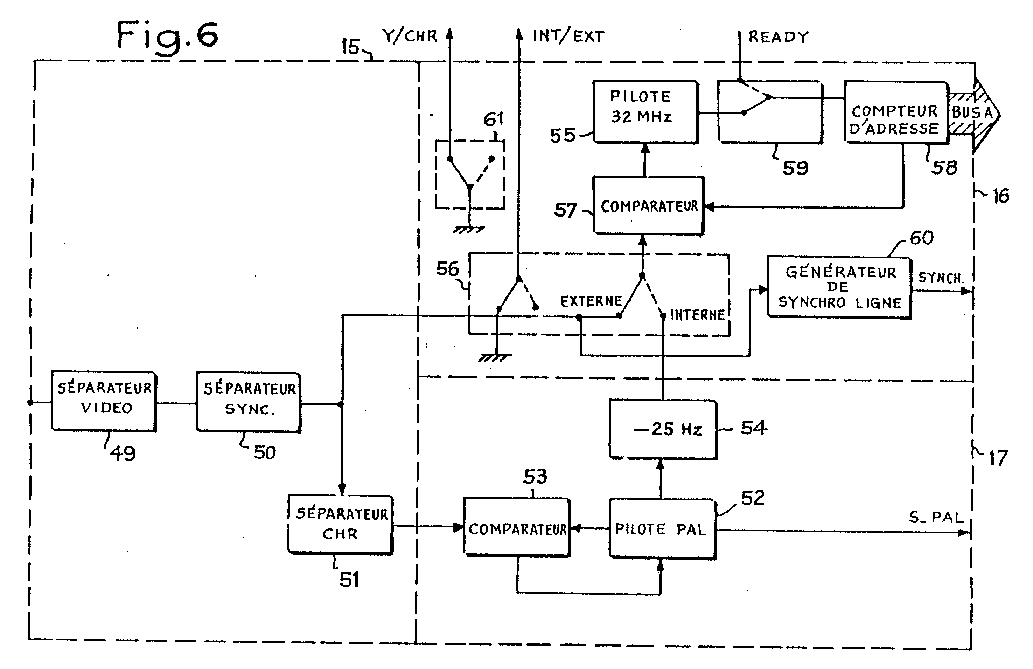

La figure 6 représente sous forme synoptique un mode de réalisation des moyens de synchronisation.

Les moyens de synchronisation sont chargés de reconstituer les signaux de synchronisation ordinaires de luminance SYNCH et de chrominance S/PAL des signaux de télévision. Ces moyens de synchronisation peuvent eux-mêmes être synchronisés à partir d'un générateur externe de signaux de télévision situé par exemple dans une station de télévision ou travailler uniquement en mode interne en synchronisation avec une horloge interne.

Lorsque le dispositif de génération de signaux de test est alimenté par un générateur externe de signaux de télévision, le générateur applique un signal de télévision à l'entrée du générateur de synchronisation 15. Le générateur de synchronisation 15 est constitué par un étage séparateur du signal vidéo 49 qui reçoit sur son entrée le signal de télévision et qui alimente sur sa sortie le séparateur 50 des tops de synchronisation. Il est constitué également par un étage de séparation des signaux de chrominance 51 couplé sur son entrée à la sortie du séparateur de synchronisation 50. Le séparateur 51 alimente par sa sortie l'entrée du générateur 17 de signaux de synchronisation standard PAL qui est composé d'une façon connue par un oscillateur 52 et un comparateur 53 qui délivre une tension de commande de l'ajustement de la fréquence de l'oscillateur lorsqu'un écart est détecté entre la fréquence de l'oscillateur et la fréquence des signaux délivrés par le séparateur de signaux de chrominance 51. La fréquence de l'oscillateur 52 est décalée de 25 périodes par un soustracteur de fréquences 54 qui reçoit sur son entrée la fréquence du standard de télévision PAL délivrée par l'oscillateur 52.

Le générateur de signaux de synchronisation 16 est constitué par un oscillateur 55 de fréquence 32 MHz qui est synchronisé sur la fréquence délivrée par le séparateur de synchronisation 50 ou sur la fréquence délivrée par le soustracteur de fréquence 54. L'aiguillage sur l'une de ces deux fréquences s'effectue à l'aide du commutateur 56 qui connecte en mode de fonctionnement externe la sortie du séparateur 50 à l'entrée du comparateur 57 et en mode de fonctionnement interne la sortie du soustracteur 54 à l'entrée du comparateur 57. Le commutateur 56 transmet également le signal INT/EXT à destination de l'interface 10 pour commander les sélecteurs 31 à 34.

Le générateur 16 comprend également un compteur d'adresse 60 dont les sorties sont directement reliées au bus d'adresse BUSA, pour réaliser l'adressage de la mémoire à lecture-écriture 8 et de la mémoire morte 12. Un aiguilleur 59 commandé par le calculateur 9 connecte l'entrée d'horloge du compteur 59 soit à la sortie de l'oscillateur 55, soit à la sortie de l'interface d'entrée-sortie 10 qui transmet

5

le signal READY provenant du calculateur. De cette façon les échantillons mémorisés dans la mémoire 19 du calculateur 9 peuvent être transférés dans la mémoire à lecture-écriture 8 au rythme du signal « READY » transmis par le calculateur et peuvent être lus dans la mémoire à lecture-écriture au rythme du signal à 32 MHz délivré par l'oscillateur 55. Un commutateur 61 transmet le signal Y/CHR de sélection des échantillons de luminance et de chrominance à destination de l'interface 10.

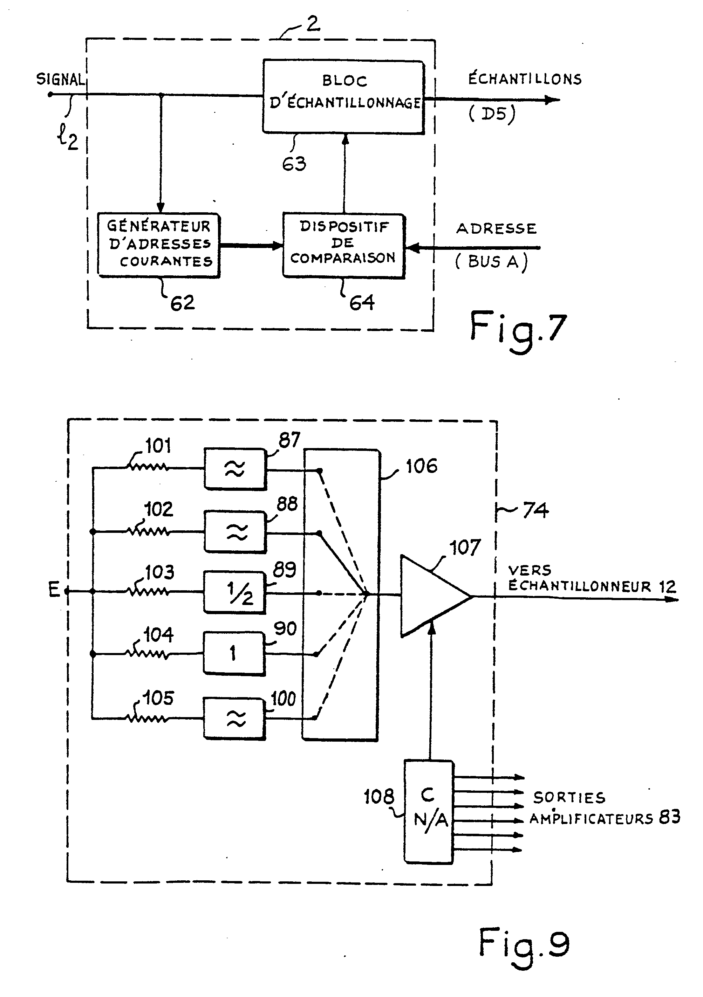

Le dispositif de saisie des signaux numériques 2 est représenté sous forme synoptique à la figure 7, il comprend un générateur d'adresses courantes 62, un bloc d'échantillonnage 63 et un dispositif de comparaison 64. L'expression « adresse courante » désigne ici l'adresse du point courant de l'image de télévision qui est en cours de transmission, le signal de télévision associé étant appliqué à l'entrée du dispositif pour être éventuellement saisi.

Ce signal est transmis suivant une séquence correspondant à l'analyse de l'image par l'équipement de télévision à tester 4 qui peut être une caméra de télévision, un émetteur de télévision, ou tout autre générateur d'image de télévision ; il est appliqué, par la ligne $l_2$, aux entrées respectives du générateur d'adresse courante 62 et du bloc d'échantillonnage 63. A un instant donné, le générateur d'adresse courante 62 calcule pour le signal de télévision reçu, l'adresse du point de l'image qui lui correspond et transmet cette adresse à une entrée du dispositif de comparaison 64. Le dispositif de comparaison 64 reçoit sur une autre entrée par le bus d'adresse BUSA l'adresse du point désigné dans l'image pour lequel une caractérisation du signal de télévision correspondant est demandée par le calculateur 9 pour comparer cette adresse à l'adresse courante délivrée par le générateur d'adresse courante 62. Le résultat de la comparaison est transmis à une entrée de commande du bloc d'échantillonnage 63. Lorsque le bloc d'échantillonnage 63 est commandé par le dispositif de comparaison 64 le signal de télévision qui est présent à l'entrée du bloc d'échantillonnage 63 est pris en compte par le bloc d'échantillonnage pour être converti en une suite d'échantillons numériques qui sont transmis par la ligne de données $D_5$ à destination de l'interface 10 du dispositif de génération de signaux de test de la figure 2.

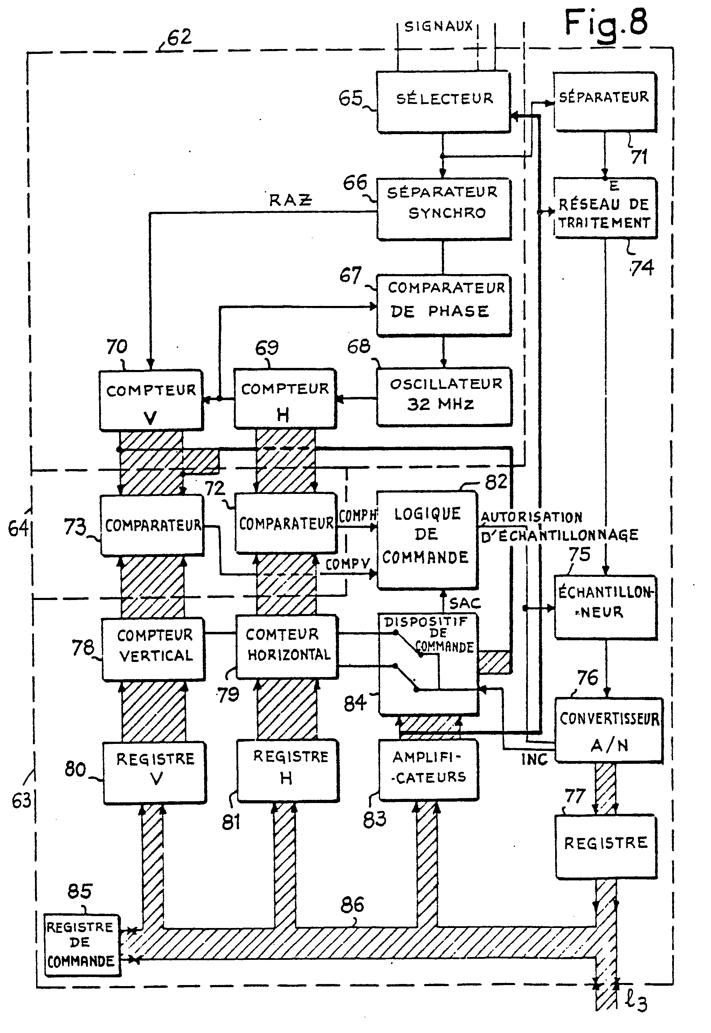

Les détails de réalisation du dispositif représenté à la figure 7 sont maintenant décrits à l'aide du mode de réalisation de l'invention représenté à la figure 8. Sur cette figure, le générateur d'adresse courante 62, représenté à l'intérieur d'un rectangle en lignes pointillées comprend un sélecteur d'entrées 65, un séparateur de synchronisation 66, un dispositif d'asservissement d'horloge interne composé d'un comparateur de phase 67, d'un oscillateur 68 et d'un compteur d'adresses horizontales programmables 69 ainsi que d'un compteur d'adresses verticales programmables 70. Le sélecteur d'entrées 65 comprend plusieurs entrées qui peuvent être chacune reliées à plusieurs sorties de l'équipement de télévision à tester 4 pour être connectées sélectivement à l'entrée du dispositif de saisie. Le signal de télévision transmis par la sortie sélectionnée est reçu à l'entrée d'un séparateur de synchronisation 71 qui sépare du signal de télévision les tops de synchronisation de ligne et de trame. Les tops de synchronisation de ligne sortant du séparateur 66 sont appliqués sur une entrée du comparateur de phase 67 qui reçoit sur une autre entrée des tops de même fréquence que celle des tops de synchronisation de ligne délivrés par le compteur 69. Le compteur 69 est composé de dix basculeurs et a une capacité de 2 048, il progresse au rythme des signaux délivrés par l'oscillateur 68, dont la fréquence est dans l'exemple particulier de réalisation de l'invention de 32 MHz. Les tops d'horloge délivrés par le compteur 69 ont par conséquent une période de 64 microsecondes qui correspond à la durée d'une ligne de balayage d'une image de télévision standard. Le comparateur 67 compare la phase des tops des signaux transmis par le compteur 69 à la phase des tops de synchronisation de ligne du signal de télévision reçu pour délivrer un signal de commande d'ajustement de la phase des signaux émis par l'oscillateur 68 de façon à annuler l'écart de phase entre les tops de synchronisation reçus et les tops délivrés par le compteur 69. Les tops délivrés par le compteur 69 sont également appliqués à l'entrée du compteur vertical 70 pour lui permettre de progresser au rythme des tops de synchronisation ligne du signal de télévision et de compter les lignes d'image reçues par le dispositif. Dans l'exemple particulier de réalisation de l'invention, le compteur 70 est composé de dix basculeurs et est remis à zéro par les tops RAZ de synchronisation de trame délivrés par le séparateur de synchronisation 66, toutes les 625 lignes, pour pouvoir fonctionner avec un système de télévision possédant 625 lignes par image. Les sorties des compteurs 69 et 70 sont connectées respectivement à des premières entrées des comparateurs 72 et 73 composant le dispositif de comparaison 64, et transmettent par conséquent aux entrées de ces comparateurs, les adresses du point d'image courant à l'intérieur de l'image de télévision. La position d'adresse de la ligne étant fournie par le compteur 70 et la position ou l'adresse du point sur la ligne étant fournie par le compteur 69.

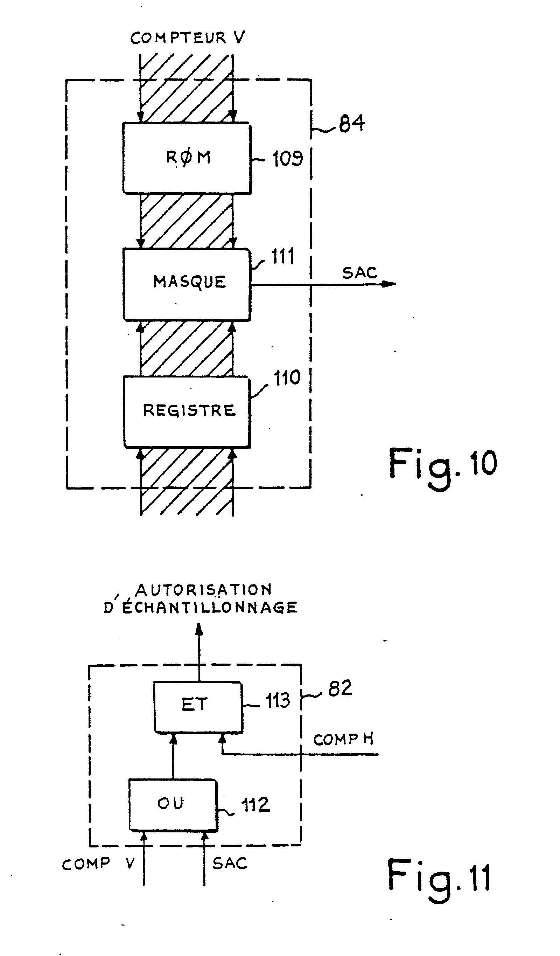

Le bloc d'échantillonnage 63 est représenté à l'intérieur de lignes en pointillés sur la figure 8. Il comprend un séparateur du signal de télévision 71, un réseau 74 de traitement et de mise en format du signal de télévision, un échantillonneur 75, un convertisseur analogique-numérique 76, et un registre 77. Le bloc d'échantillonnage 63 comprend également des compteurs d'adresse programmables 78 et 79, dont les entrées programmables sont respectivement reliées aux sorties de registres 80 et 81, et dont les sorties sont reliées à des deuxièmes entrées des comparateurs 73 et 72 respectivement, une logique de commande 82, des amplificateurs de commande 83, un dispositif de commande 84 de la progression des compteurs 78 et 79 et de commande de la logique de commande 82 ainsi qu'un registre de commande 85. Un bus 86 de transmission bi-directionnel de signaux relie les entrées des registres 80, 81 et des amplificateurs 83 ainsi que les entrées du registre de commande 85, et les sorties du registre 77 pour réaliser la connection du dispositif au bus d'adresses BUSA et de données $D_5$ du dispositif de génération de signaux de test de la figure 2 par l'intermédiaire de la ligne $I_3$. L'amplificateur séparateur de signaux de télévision 71 a son entrée reliée à la sortie du sélecteur 65 et reçoit ainsi le signal de télévision sélectionné par le sélecteur d'entrée. La sortie du séparateur 71 est reliée à l'entrée du réseau 74 de traitement et de mise en format du signal de télévision dont les éléments constitutifs sont représentés à la figure 9.

Le réseau de traitement et de mise en format de la figure 9 est constitué d'un filtre passe-bas 87, d'un filtre passe-haut 88, d'un atténuateur 89, de rapport d'atténuation 1/2, d'un atténuateur 90 de rapport d'atténuation 1, et d'un filtre passe-bas 100. Les entrées des éléments précités sont reliées respectivement à l'entrée E du réseau 74 à travers les résistances respectives 101 à 105. Les sorties respectives des éléments précités 87 à 100 sont reliées aux entrées respectives d'un sélecteur 106 dont la sortie est reliée à l'entrée d'un amplificateur à gain variable 107 commandé par la sortie d'un convertisseur numérique-analogique 108. Les entrées du convertisseur numérique-analogique 108 sont reliées respectivement aux sorties des amplificateurs de commande 83. Le réseau de traitement et de mise en format 74 peut donc être commandé directement, à partir des informations de commande provenant du calculateur 9 de façon à sélectionner le mode désiré de traitement du signal, en positionnant l'entrée correspondante du sélecteur 106 sur un des éléments de correction 87 à 100 et en ajustant le niveau de sortie du convertisseur numérique-analogique 108 pour ajuster le gain de l'amplificateur 107. Le signal sortant de l'amplificateur 107 est ensuite appliqué à l'entrée de l'échantillonneur 75 de la figure 8. L'échantillonneur 75 a son entrée de commande reliée à la sortie de la logique de commande 82 qui délivre un signal de commande lorsqu'une autorisation de conversion est donnée par le dispositif de comparaison 64 ou par le dispositif de commande 84.

Le dispositif de commande 84 est représenté à la figure 10, il se compose d'une mémoire ROM 109 adressée sur ses entrées par le compteur vertical 70, d'un registre 110 d'autorisation de fonctionnement relié par ses entrées aux sorties des amplificateurs 83 et d'un circuit de masque 111 ayant des premières entrées reliées aux sorties de la mémoire 109 et des deuxièmes entrées reliées aux sorties du registre 110.

La mémoire 109 contient des autorisations de conversion préprogrammées pour des lignes particulières de l'image de télévision, permettant par exemple de sélectionner des lignes de test particulières dans chaque trame de l'image, ou d'effectuer des mesures sur une trame complète. Les autorisations préprogrammées apparaissent sur les fils de sortie de la mémoire 109 lorsqu'elles sont convenablement adressées par le compteur 70. Ces autorisations peuvent être toutes validées ou partiellement masquées par les bits d'information de masquage contenus dans le registre 110 qui y ont été chargés au préalable par le calculateur extérieur au dispositif. La validation des autorisations de conversion est effectuée d'une façon connue par le circuit de masque 111 qui délivre sur sa sortie un signal d'autorisation de conversion SAC, chaque fois qu'une autorisation de conversion délivrée sur une sortie de la mémoire 109 est validée par le contenu du registre 110. Le signal d'autorisation de conversion SAC est transmis sur la sortie du dispositif de commande 84 à destination de la logique de commande 82.

La logique de commande 82 est représentée à la figure 11. Elle comprend une porte OU 112 reliée par une première entrée à la sortie du dispositif de commande 84 transmettant le signal SAC, par une deuxième entrée à la sortie du comparateur vertical 73, et par sa sortie à une première entrée d'une porte ET 113 dont l'autre entrée est reliée à la sortie du comparateur horizontal 72. La sortie de la porte ET 113 constitue la sortie de la logique de commande 82 et délivre un signal de commande d'échantillonnage chaque fois qu'une égalité d'adresse est détectée par le comparateur vertical 73 ou qu'un signal d'autorisation de conversion SAC est délivrée par le dispositif de commande 84 et que le comparateur horizontal 72 trouve une égalité d'adresse entre les contenus des compteurs 69 et 79.

Lorsque le dispositif d'échantillonnage 75 est commandé par la logique de commande 82, l'échantillon du signal mesuré par le dispositif d'échantillonnage 75 est appliqué à l'entrée du convertisseur numérique-analogique 76. La logique de commande 82 déclenche également un cycle de conversion du convertisseur analogique-numérique 76 pour transformer l'amplitude de l'échantillon appliqué sur l'entrée du convertisseur en une grandeur numérique qui est transmise à l'entrée du registre de mémorisation 77. Le registre 77 sert de tampon entre le dispositif de saisie et l'interface 10 couplé au calculateur 9.

A la fin de son cycle de conversion, le convertisseur analogique-numérique 76 envoie un signal INC à destination des compteurs programmables 78 ou 79 pour incrémenter de une unité leur contenu. Cette incrémentation est autorisée par les amplificateurs de commande 83 qui reçoivent sur leurs entrées des impulsions de commande transmises par le calculateur 9 au travers de l'interface 10 au moyen de la ligne $D_5$.

Les moyens de visualisation 3 sont constitués par l'écran 22 du calculateur 5 et permettent une représentation graphique du signal de télévision à caractériser. Pour cela le calculateur transfère dans sa mémoire centrale 19 l'ensemble des données relatives à une ou deux lignes de télévision correspondant à 4 ou 8 K octets si l'on considère un ensemble de 2 048 points par ligne. La grandeur de chaque échantillon est reproduite sur l'écran, à un rythme défini par le calculateur de façon que les échantillons soient reproduits dans l'ordre des instants d'échantillonnage, de façon à reconstituer le signal de télévision saisi. Les dispositifs de visualisations permettant d'obtenir ce résultat sont bien connus dans l'état de la technique et par conséquent leur structure n'a pas besoin d'être décrite.

Il sera d'ailleurs possible de perfectionner le dispositif de visualisation en dotant le calculateur de moyens de programmation supplémentaires pour régler à volonté les intervalles entre les échantillons successifs situés sur l'axe horizontal de l'écran et pour créer un marqueur automatique donnant les valeurs numériques amplitude et temps de point marqué.

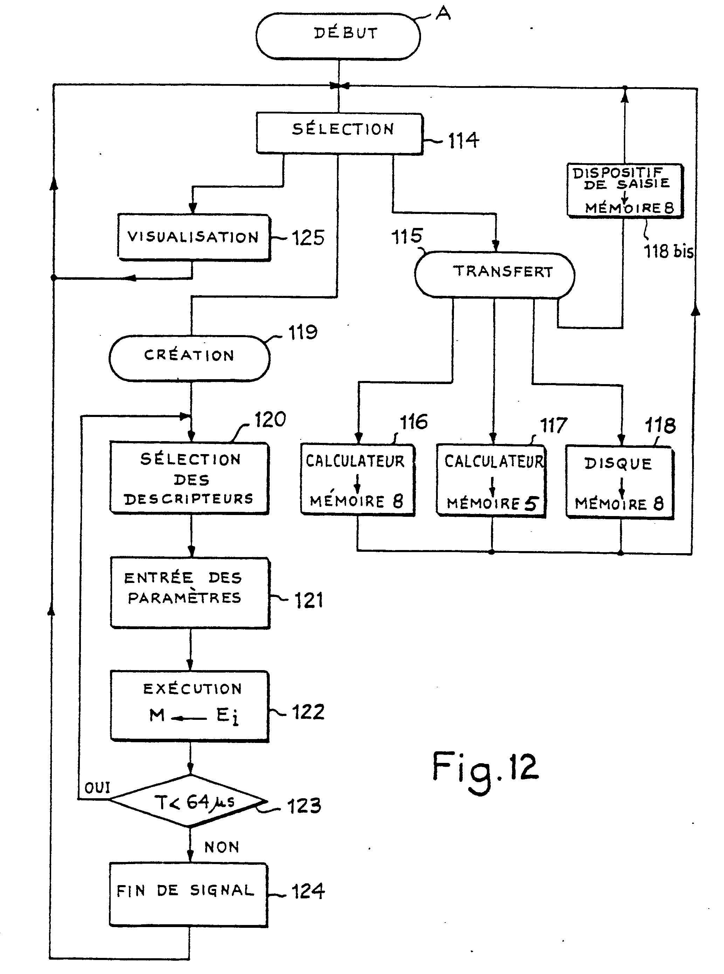

Le fonctionnement du dispositif qui vient d'être décrit est maintenant expliqué à l'aide de l'organigramme de la figure 12 qui représente les différentes procédures que le calculateur 9 peut exécuter.

L'exécution de ces procédures a lieu de façon interactive par un dialogue qui s'établit entre le calculateur 9 et un opérateur placé devant le clavier 21 et l'écran 22.

A l'étape 114, le calculateur 9 offre à l'opérateur le choix entre trois types de procédures. Un premier type de procédure, dit de transfert 115, exécutable aux étapes 116 à 118, permet d'exécuter, soit des transferts d'information (étape 116) entre la mémoire centrale 19 du calculateur 9 et la mémoire à lecture-écriture 8, soit des transferts d'informations entre la mémoire centrale 19 du calculateur 9 et la mémoire du dispositif de mémorisation 5 (étape 117), soit des transferts d'informations en direct ou en passant par le calculateur 9 entre la mémoire à lecture-écriture 8 et le dispositif de mémorisation 5 (étape 118), ou encore des transferts en direct ou non entre le registre 77 du dispositif de saisie et la mémoire à lecture-écriture 8 (étape 118 BIS).

Chacune des procédures représentées aux étapes 115 à 118 fait appel pour son déroulement à l'exécution d'instructions d'entrée-sortie bien connues dans l'état de la technique et qui par conséquent n'ont pas besoin d'être décrites pour la mise en œuvre de l'invention.

Un deuxième type de procédure dite « création de signal » (119) est figuré par les étapes 120 à 124 de la figure 12. Elle permet à l'opérateur de créer à volonté une grande variété de signaux en associant de toutes les façons possibles plusieurs signaux élémentaires de configuration prédéterminée. La configuration d'un signal élémentaire peut être représentée à l'aide d'une fonction mathématique « $y = f(t)$ » quelconque dans laquelle, « $y$ » représente l'amplitude du signal et $f(t)$ une fonction mathématique du temps. A titre d'exemple $f(t)$ pourra être une constante, une fonction linéaire du temps, une fonction trigonométrique, etc. L'obtention de la fonction représentative d'un signal élémentaire est réalisée à l'aide d'un sous-programme qui peut être mémorisé à l'intérieur de la mémoire morte 20 du calculateur 9, ou qui pourra être chargé à partir de la mémoire à disque 11 dans la mémoire principale 19 au moment de son exécution.

L'exécution successive de plusieurs sous-programmes correspondant chacun à une fonction « $y = f(t)$ » permet de cette façon d'obtenir une suite de signaux élémentaires se succédant dans le temps.

Le sous-programme associé à chaque signal élémentaire est adressé à partir d'un descripteur de signal qui fournit l'adresse de début de sous-programme dans la mémoire morte 20 du calculateur ainsi que l'adresse $AZ_1$ de la zone de donnée située dans la mémoire centrale 19 où sont rangés les échantillons numériques du signal lors de l'exécution du sous-programme.

Chaque descripteur est sélectionné à l'étape 120 par l'opérateur qui frappe sur le clavier le type du descripteur désiré. A l'étape 121 les paramètres du signal sont introduits dans la mémoire centrale 19 aux adresses spécifiées par les zones 26 à 28 BIS du descripteur.

A l'étape 122 le sous-programme adressé par le descripteur sélectionné est lancé.

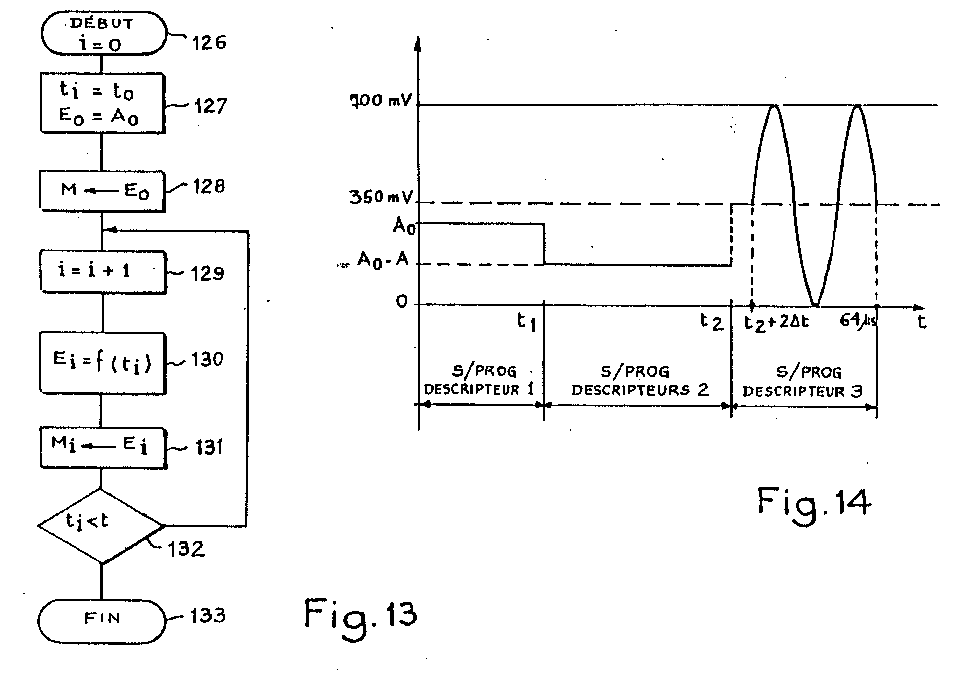

Un organigramme type d'exécution d'un sous-programme est montré à la figure 13. Au début, à l'instant $t = t_0$, au cours des étapes 126 à 128, l'amplitude du premier échantillon $E_0$ est rendue égale à $A_0$ et l'échantillon $E_0$ est rangé à la première adresse de la zone de donnée en mémoire centrale pointée par le descripteur correspondant. Puis aux instants $t_i$ successifs, définis par la période d'échantillonnage, le sous-programme calcule, aux étapes 128 et 130 l'amplitude des échantillons $E_i$ selon l'équation $E_i = f(t_i)$ où f est la fonction mathématique permettant d'obtenir l'amplitude du signal en fonction du temps. A l'étape 131 les échantillons $E_i$ calculés sont rangés aux adresses successives de la zone de donnée réservée au descripteur. Le calcul s'arrête après l'étape 132 à l'étape 133 lorsque l'instant $t_i$ de calcul atteint l'instant final indiqué par la zone d'adresse $AZ_4$ du descripteur.

Des exemples types de lancement de sous-programmes sont donnés ci-après pour des descripteurs de signaux respectivement sans changement, avec transition ou représentant des fréquences.

(Siehe Tabelle Seite 9 f.)

A la fin d'exécution d'un sous-programme la procédure renvoie l'opérateur à l'étape 120 pour lui demander de sélectionner un autre descripteur de signal.

Plusieurs descripteurs peuvent être ainsi sélectionnés tant que la somme des temps représentant la durée de chaque signal élémentaire ne dépasse pas la durée de 64 µs d'une ligne de balayage d'une image de télévision.

Un test est effectué par la procédure à l'étape 123 qui renvoie l'opérateur à l'étape 114 lorsque la somme des signaux élémentaires dépasse le temps de 64 µs.

Le signal, obtenu après sélection dans l'ordre des descripteurs 1, 2 et 3 précités et exécution des sous-programmes correspondants, peut être alors visualisé par l'écran 22 du calculateur (étape 125) de la façon représentée à la figure 14. Sur cette figure l'amplitude du premier signal élémentaire correspondant au descripteur n° 1 est constante et égale à $A_0$, de l'instant $t = 0$ à l'instant $t = t_1$. L'amplitude du deuxième signal élémentaire correspondant au descripteur n° 2 est également constante mais égale cette fois-ci à $A_0$-A de l'instant $t_1$ à l'instant $t_2$. Le signal obtenu par l'exécution du sous-programme

| Types | Commentaires |
|---|---|
| Descripteur 1 : sans changement<br><br>Anciens paramètres :  Amplitude $A_o$<br>$\qquad\qquad\qquad$ Temps $\quad t_o$<br>Nouveaux paramètres : Temps $\quad t = t_1$<br>Test FIN $\quad 64\,/\mathrm{us}$ | entrée des paramètres |
| S/PROG.  Pour $t_i$ tel que $t_o \langle t_i \langle t_1$<br>$\qquad$ Faire $M(i) \leftarrow A_o = E_i$ | Exécution du sous<br>programme $y=f(t)=A_o$ |
| Descripteur 2 : Transition<br><br>Anciens paramètres :  Amplitude $A_o$<br>$\qquad\qquad\qquad$ Temps $\quad t_i = t_1$<br>Nouveaux paramètres : Amplitude $A$<br>$\qquad\qquad\qquad$ Temps $\quad t_i = t_2$ | Entrée des<br>paramètres |
| Test $0 \langle A_o + A \langle 700_{\mathrm{mV}}$<br>Test $\qquad t_2 \langle 64\,/\mathrm{us}$<br>S/PROG. Pour $t_i$ tel que $t_1 \langle t_i \langle t_2$<br>$\qquad$ Faire $M(i) \leftarrow A_o - A = E_i$ | Exécution du sous<br>programme<br>$y=f(t)=A_o - A$ |
| Descripteur 3 : Fréquence<br><br>Anciens paramètres :  Amplitude $A_o - A$<br>$\qquad\qquad\qquad$ temps $\quad t = t_2$<br>Nouveaux paramètres : Fréquence $F$<br>$\qquad\qquad$ Valeur moyenne $B = 350_{\mathrm{mV}}$<br>$\qquad\qquad$ Amplitude $C = 350_{\mathrm{mV}}$<br>$\qquad\qquad$ Temps $\quad t = 64\,/\mathrm{us}$ | Entrée des paramètres<br><br>valeur moyenne |
| Test $\quad$ si $\quad A_o - A \neq B$ faire transition<br>$\qquad\qquad\quad 2\Delta T \quad B \longrightarrow 350_{\mathrm{mV}}$<br>Test $\quad$ Temps $\langle 64\,/\mathrm{us}$<br>Test $\quad$ Valeur crête $B + C \langle 700_{\mathrm{mV}}$<br>Test $\quad 0,5 \langle F \langle 12$ MHz<br>S/PROG. $M_i \leftarrow E_i = C \sin 2\pi F.t$ | Exécution du<br>sous programme<br><br>$y = B + C \sin 2\pi F.t$ |

correspondant au descripteur 3 est sinusoïdale, sa valeur B moyenne est à l'amplitude $350_{mV}$ et sa valeur crête à crête est de $700_{mV}$.

Le fonctionnement du dispositif de saisie 2 sera maintenant décrit. Les coordonnées $X_i$ et $Y_i$ du signal à caractériser sont transmises par le calculateur 9 sous la forme de signaux numériques sur le bus de liaison 86 à destination des registres 80 et 81. Le signal de télévision à caractériser est sélectionné par le sélecteur 65 et est appliqué d'une part à l'entrée du séparateur de synchronisation 66 et d'autre part à l'entrée du séparateur 71. Le calculateur 9 transmet également les bits de commande à destination du registre de commande 85 pour masquer les sorties de la mémoire morte 109 du dispositif de commande 84 et pour commander le réseau de traitement et de mise en format 74. Les adresses horizontales et verticales du signal de télévision à caractériser contenues dans les registres 80 et 81 sont transférées à l'intérieur des compteurs programmables 78 et 79. L'oscillateur 68 qui est asservi aux tops de synchronisation délivré par le séparateur de synchronisation 66, fait progresser les compteurs horizontaux et verticaux 69 et 70 qui délivrent chacun une composante de l'adresse courante du point de l'image en cours de transmission et ces adresses horizontales et verticales sont comparées aux adresses du point désiré contenu dans les compteurs 78 et 79, par les comparateurs 72 et 73. Lorsque les comparateurs 72 et 73 détectent une égalité entre les adresses courante et désirée, ils délivrent chacun un signal d'autorisation de conversion respectivement COMPH et COMPV qui sont transmis aux entrées de la logique de commande 82. Dans le même temps la mémoire morte 109 est adressée par les sorties du compteur vertical 78. Cette mémoire 109 contient les adresses des lignes pour lesquelles une caractérisation de signaux peut être directement commandée par le calculateur 9. La sélection de ces lignes est effectuée par le circuit de masque 111 qui reçoit sur ses entrées les informations de masque provenant du calculateur et transmises au travers du registre d'autorisation de fonctionnement 110. Lorsqu'il y a coïncidence entre les bits du mot d'information de masque et les bits de sortie de la mémoire morte 109 un signal d'autorisation de conversion SAC est délivré par le circuit de masque 111. La mémoire morte 109 et le circuit de masque 111 permettent de sélectionner plusieurs lignes de test insérées dans chaque trame d'image, et permettent également si la mémoire est convenablement programmée de faire des mesures sur l'ensemble d'une trame et des mesures de synchronisation de trame. Les autorisations de conversion agissent sur l'entrée de commande du convertisseur numérique-analogique 76 et déclenchent à chacune de leur apparition un cycle de conversion. A chaque fin de cycle de conversion un signal d'incrémentation INC est transmis à une entrée du dispositif de commande 84 qui retransmet ce signal aux entrées d'incrémentation des compteurs verticaux et horizontaux 78 et 79 lorsque le signal INC est validé par les amplificateurs de commande 83 recevant les signaux de commande provenant du calculateur extérieur par le bus 86. La validation du signal d'incrémentation par le dispositif de commande 84 permet par conséquent un adressage implicite des échantillons suivant quatre modes différents, un mode où il n'existe pas d'incrémentation des compteurs d'adresse 78 et 79, un mode où on incrémente seulement le compteur d'adresses horizontales 79, un mode où on incrémente seulement le compteur d'adresses verticales 78, et un mode où les deux compteurs horizontaux et verticaux 78 et 79 sont simultanément incrémentés. Dans le cas où il n'y a pas d'incrémentation le dispositif échantillonne toujours le même point de l'image, soit un point par trame ou un point par image. Dans le cas où seulement l'adresse horizontale du point d'image est incrémentée par le compteur 79 le dispositif analyse une ligne à la cadence de 1 point par image, l'adresse de la ligne étant indiquée par le contenu du compteur 78. Dans le cas d'une incrémentation verticale seule, le dispositif analyse une ligne verticale dont l'adresse correspond au contenu du compteur horizontal 79 et cette analyse se fait à la cadence d'un point par ligne. Dans le cas où il existe à la fois une incrémentation horizontale et une incrémentation verticale le dispositif analyse une ligne oblique à la cadence d'un point par ligne et les adresses des points successifs analysés sont indiquées par le contenu des compteurs 78 et 79.

Le dispositif d'adressage qui vient d'être décrit permet l'utilisation de convertisseur analogique-numérique très précis car l'analyse d'un point d'image se fait toujours à la cadence des signaux de synchronisation de trame soit, à 16 Khz dans l'exemple particulier décrit, ce qui représente une vitesse de conversion relativement lente et explique par conséquent la grande précision de caractérisation qui peut être obtenue.

L'adressage implicite ci-dessus est réalisé par les compteurs d'adresses 78 et 79 et complété par un adressage explicite réalisé par le dispositif de commande 84 qui sera utilisé plus particulièrement pour les caractérisations de signaux très usuels ou standardisés des signaux de télévision, notamment pour la caractérisation des paramètres des signaux de test insérés dans l'effacement de trame aux lignes 17, 18, 330 et 331.

Il va de soi que le principe de réalisation de l'invention permet d'obtenir de très nombreuses variétés de signaux en agissant, soit sur l'ordre de sélection des descripteurs, car à n descripteurs on peut faire correspondre $n! = 1 \times 2 \dots n$ signaux possibles, soit en agissant sur la valeur des paramètres introduits dans chaque descripteur ou en agissant encore au niveau du choix des fonctions mathématiques représentant les différents signaux élémentaires. Dans tous les cas on notera que la création d'un nouveau signal n'entraîne aucune modification au niveau des dispositifs matériels, et qu'elle entraîne tout au plus l'écriture d'un nouveau sous-programme de calcul d'échantillonnage correspondant à la nouvelle fonction mathématique introduite qui ne doit pas faire de difficulté pour les programmeurs bien avertis des techniques de programmation.

Les signaux de test $V_S$ issus du dispositif de génération des signaux analogiques par la sortie du convertisseur numérique-analogique 6 sont appliqués par la ligne $l_1$ à l'équipement à tester qui peut être, par exemple, l'entrée d'un émetteur de télévision et les signaux de sortie correspondant de l'équipement à tester où de l'émetteur de télévision sont appliqués par la ligne $l_2$ à l'entrée du dispositif de saisie 2 afin d'être mis dans un format exploitable par le calculateur 9 et être rangés après transmission sur la ligne $l_3$ dans la mémoire centrale 19 selon une suite de N échantillons numérisés.

Cette suite pourra alors subir un traitement mathématique dépendant de la tâche à effectuer et qui consistera généralement à effectuer des opérations de lissage, d'interpolation, d'évaluation statistique pour permettre au calculateur de donner les résultats de la caractérisation du signal demandée.

Il n'est naturellement pas possible de donner ici une liste exhaustive de l'ensemble des caractérisations de signaux que le dispositif de la présente invention peut effectuer puisque du fait de la solution numérique adoptée le nombre n'en est pas limité. Le calculateur devra pour chaque cas être convenablement programmé en fonction de la nature des signaux de test qui devront être appliqués à l'équipement à tester et en fonction des traitements mathématiques que l'opérateur désirera faire subir aux signaux restitués par le dispositif de saisie.

Le dispositif selon l'invention pourra être avantageusement utilisé en télévision à la mesure par exemple de l'amplitude du blanc du signal de référence, à la mesure de la chrominance du signal de télévision, à la caractérisation du transitoire d'impulsions ou de transitions de signaux.

La mesure de l'amplitude du blanc du signal de référence pourra être effectuée sur la ligne internationale de test n° 17 de la trame d'image, à un instant $t_{14}$ de 14 microsecondes après le début du top de synchronisation de ligne. Le programme de saisie consistera alors à demander au dispositif de saisie de capter les valeurs d'échantillons $Y_i$ du signal un nombre N de fois à proximité de l'instant $t_{14}$. Le calculateur exécutera alors un sous-programme de calcul pour calculer la valeur moyenne des échantillons $\Sigma Y_i/N$ pour donner la valeur du signal correspondant au niveau de blanc, d'autres sous-programmes pourront également être exécutés pour donner le rapport signal/bruit, la déclivité éventuelle du signal, etc... A l'aide d'un programme plus évolué on pourra effectuer au préalable, la mesure du niveau du noir du signal de télévision pour obtenir la valeur vraie du niveau du blanc et compte tenu des écarts mesurés dus au bruit, le dispositif de saisie sera commandé pour saisir un nombre de données suffisantes pour que la mesure effectuée soit significative.

La mesure de la chrominance du signal de télévision pourra être effectuée, soit sur la ligne 330, ou sur la ligne 331 du standard international de télévision PAL qui contiennent les signaux destinés à cet usage. En captant le signal toujours au même endroit dans la trame de l'image le dispositif de saisie capte toujours un échantillon de signal par image et comme la composante du signal de chrominance du signal PAL dans une image est déphasée de 90° par rapport à la composante de chrominance de l'image précédente, il est facile par ce moyen de reconstituer dans une suite de $4 \times N$ valeurs successives, les composantes de luminance et de chrominance, en amplitude et en phase du signal PAL.

La caractérisation d'un transitoire requiert la saisie d'une suite de données contenant la transitoire à caractériser, le calcul, par une des méthodes d'interpolation curviligne connues, par exemple la Méthode d'Interpolation de Lagrange des valeurs Vi aux instants intermédiaires, ou le calcul par interpolation linéaire en fin des instants caractéristiques du transitoire par exemple aux instants T0 et T1 des valeurs à demi-amplitude de l'impulsion.

Une procédure plus évoluée peut donner, par examen de la suite des valeurs saisies et des valeurs interpolées les dépassements balistiques avant et arrière de l'impulsion. On peut imaginer de calculer un gabarit de facteur « k » qui n'est pas intercepté par le signal ainsi reconstitué.

En général, pratiquement, tous les paramètres usuels du signal de télévision peuvent être caractérisés par un traitement de la suite de données numériques acquises dans des conditions convenables. Avec un dispositif de saisie à 10 bits et un intervalle de saisie de 32 NS, la précision de caractérisation dépasse largement 1 %.

Le dispositif selon l'invention est capable d'effectuer des caractérisations relativement complexes grâce à son dispositif de génération de signaux de test qui lui permet de créer un signal de test spécifique, facilitant la caractérisation désirée. Un exemple type serait la caractérisation de la fonction « temps de transit ».

Cette caractérisation requiert habituellement un appareillage compliqué et coûteux. En créant un signal de test de fréquence et de phase connue, référencée par rapport aux instants de synchronisation horizontale du signal de télévision, le dispositif selon l'invention permet la caractérisation du temps de transit dans une bande passante fonction de la fréquence d'échantillonnage du système.

Bien que le dispositif qui vient d'être décrit s'applique plus particulièrement à la caractérisation de signaux de télévision, il va de soi que ce dispositif peut très bien être utilisé dans d'autres systèmes de caractérisation de signaux, on comprendra que ce dispositif peut être facilement inséré parmi d'autres constituants d'un ensemble de caractérisation ou de mesure assisté par calculateur. Dans ce cas le fonctionnement du dispositif sera déterminé par un programme de caractérisation ou de mesure qui déterminera les paramètres de saisie totale ou fragmentaire des signaux qui sont nécessaires à l'exécution de la tâche qui est en cours. Par exemple ce programme déterminera l'adresse horizontale et verticale du point de départ des signaux à saisir, le nombre de points à saisir, les conditions de la saisie, ainsi que la trajectoire de la saisie. Le calculateur passera alors les paramètres de commande au dispositif qui les rangera dans ses registres de commande ou de contrôle correspondants. Le dispositif acquerra les données demandées et les transmettra au fur et à mesure au calculateur qui les rangera ou les accumulera en mémoire centrale et arrêtera le processus lorsque les données seront complètement transférées.

**Revendications**

1. Dispositif de test d'équipements électroniques (4), comprenant un dispositif (1) de génération de signaux analogiques de test à destination de l'équipement à tester comprenant un calculateur numérique (9), couplé à un dispositif de conversion numérique analogique (6) et à des moyens (5) de mémorisation de signaux de test sous la forme d'échantillons numériques, un dispositif (2) de saisie des signaux fournis par l'équipement électronique testé en réponse aux signaux de test reçus par l'équipement, ainsi que des moyens de visualisation (3) commandés par le calculateur pour visualiser les signaux transmis par le dispositif de génération de signaux de test et/ou les signaux reçus par le dispositif de saisie, le calculateur numérique (9) comprenant des moyens (18, 10, 20, 21) de création de signaux de test sous la forme d'échantillons numériques ainsi que des moyens pour transférer (8) les échantillons mémorisés à l'intérieur des moyens de mémorisation et les échantillons créés par les moyens de création à destination du dispositif de conversion numérique-analogique, caractérisé en ce que, les moyens de création des signaux de test sous la forme d'échantillons sont constitués par une unité de traitement micro-programmée (18), couplés respectivement à des moyens de mémorisation (20) de descripteurs de signaux de test, à des moyens (19, 20) de mémorisation de séquences d'instructions de programme, à des moyens (19) de mémorisation de données pour l'obtention des échantillons pour permettre l'adressage aux moyens de mémorisation des descripteurs de signaux de test et à un clavier (21) et les moyens de mémorisation des descripteurs de signaux de test comprennent pour chaque descripteur une zone (24) indiquant le type du descripteur, une zone (25) de mémorisation de l'adresse de début de la séquence d'instruction pour l'obtention des échantillons correspondant à ce descripteur, des zones d'adresses (26, 27, 28, 28 BIS) de zone de travail pour le rangement des paramètres relatifs au signal dans les moyens de mémorisation de données et une zone d'adresses pour identifier (26) le début d'une zone de rangement des échantillons dans les moyens de mémorisation de données.

2. Dispositif selon la revendication 1, caractérisé en ce que la zone de travail pour ranger les paramètres comprend :
— une zone (26) pour ranger un paramètre donnant l'amplitude du premier échantillon du signal,
— une zone (27) pour ranger un paramètre donnant l'amplitude du dernier échantillon,
— et une zone (28) pour ranger l'instant de génération du dernier échantillon.

3. Dispositif selon l'une quelconque des revendications 1 et 2, caractérisé en ce que le dispositif de génération de signaux analogiques de test comprend une mémoire à lecture-écriture (8) interposée entre le dispositif de conversion numérique-analogique (6) et les moyens de mémorisation (5) ainsi que des moyens (7) pour synchroniser le transfert des échantillons mémorisés à l'intérieur de la mémoire à lecture écriture à destination du dispositif de conversion numérique-analogique.

4. Dispositif selon la revendication 3, caractérisé en ce que la mémoire à lecture-écriture (8) est adressée par un compteur d'adresse (58) commandé par le calculateur pour l'écriture des échantillons dans la mémoire à lecture-écriture et commandé par les moyens de synchronisation pour la lecture des échantillons dans la mémoire à lecture-écriture.

5. Dispositif selon l'une quelconque des revendications 1 à 4, caractérisé en ce qu'il comprend en outre des démultiplexeurs (46, 47) pour l'écriture des échantillons dans la mémoire à lecture-écriture et un multiplexeur (48) pour le transfert des échantillons de la mémoire à lecture-écriture à destination du convertisseur analogique-numérique.

6. Dispositif selon la revendication 5, caractérisé en ce que les démultiplexeurs (46, 47) sont commandés par le calculateur.

7. Dispositif selon l'une quelconque des revendications 3 à 6, caractérisé en ce que le multiplexeur (48) est commandé par les moyens de synchronisation.

8. Dispositif selon l'une quelconque des revendications 1 à 7, caractérisé en ce que le dispositif de saisie comprend, un générateur (62) de l'adresse courante du signal se présentant à l'entrée du dispositif, un bloc d'échantillonnage (63) du signal reçu par le dispositif et un dispositif de comparaison (64) relié par une entrée à la sortie du générateur d'adresse courante, une autre entrée du dispositif de comparaison (64) recevant l'adresse du signal devant être saisi et la sortie du comparateur délivrant un signal de commande du bloc d'échantillonnage (63) pour l'autoriser à saisir le signal courant présent à l'entrée du dispositif lorsque l'adresse du signal courant est égale à l'adresse du signal qui doit être saisi.

9. Dispositif selon la revendication 8, caractérisé en ce que le bloc d'échantillonnage (63) comprend un échantillonneur (75) et un dispositif de commande (84) adressé par le générateur d'adresse courante pour délivrer des signaux de commande préprogrammés à l'échantillonneur.

10. Dispositif selon la revendication 9, caractérisé en ce que le bloc d'échantillonnage (63) comprend un registre de commande (85) pour valider ou partiellement masquer les signaux de commande préprogrammés délivrés par le dispositif de commande (84).

11. Dispositif selon l'une quelconque des revendications 9 et 10, caractérisé en ce que le bloc d'échantillonnage (63) comprend un convertisseur numérique-analogique (76) relié à la sortie de l'échantillonneur (75).

12. Appareil de test d'équipement de télévision, caractérisé en ce qu'il comprend un dispositif tel que revendiqué dans les revendications 1 à 11.

13. Appareil selon la revendication 12, caractérisé en ce que le dispositif de saisie de signaux de télévision provenant de l'équipement testé comprend un générateur (62) d'adresse courante composé d'un premier compteur (69) progressant au rythme des instants d'échantillonnage du signal du point courant de l'image de télévision qui est présent à l'entrée du dispositif de saisie pour donner l'adresse du point courant sur sa ligne dans l'image de télévision et d'un deuxième compteur (70) progressant au rythme des signaux de synchronisation de ligne du signal de télévision pour donner l'adresse de la ligne du point courant.

14. Appareil selon les revendications 12 et 13, caractérisé en ce que le dispositif de saisie des signaux de télévision comprend un bloc d'échantillonnage (63) comprenant un premier registre (81) de mémorisation de l'adresse du point sur la ligne à échantillonner et un deuxième registre (80) de mémorisation de l'adresse de ligne du point à échantillonner.

15. Appareil selon l'une quelconque des revendications 12 à 14, caractérisé en ce que le bloc d'échantillonnage comprend également un premier et un deuxième compteur (79, 78) programmables pouvant être chargés respectivement par le contenu des premier et deuxième registres (81, 80) de mémorisation du point à échantillonner.

16. Appareil selon l'une quelconque des revendications 12 à 15, caractérisé en ce que le dispositif de comparaison (64) du dispositif de saisie comprend un premier comparateur (72) relié par une entrée à la sortie du premier compteur du générateur d'adresses courantes et relié par une deuxième entrée à la sortie du premier compteur (79) programmable du bloc d'échantillonnage ainsi qu'un deuxième comparateur (73) relié par une entrée à la sortie du deuxième compteur (70) du générateur des adresses courantes et relié par une deuxième entrée à la sortie du deuxième compteur (73) programmable du bloc d'échantillonnage (63) pour détecter une égalité entre l'adresse du point courant et l'adresse du point désiré contenue dans les premier et deuxième compteur programmables (79, 78) et autoriser la commande de l'échantillonneur (75).

17. Appareil selon l'une quelconque des revendications 12 à 15, caractérisé en ce que le convertisseur analogique-numérique (76) du dispositif d'échantillonnage délivre en fin de cycle de conversion des signaux pour incrémenter d'une unité le contenu des premier et deuxième compteur programmables (78, 79).

18. Appareil selon l'une quelconque des revendications 12 à 17, caractérisé en ce que les signaux pour incrémenter le contenu des premier et deuxième compteur programmables sont validés par le dispositif de commande (84) du dispositif de saisie des signaux de télévision.

19. Appareil selon l'une quelconque des revendications 12 à 17, caractérisé en ce que le bloc d'échantillonnage comprend également un réseau de traitement (74) des signaux de télévision reçus, interposé entre l'échantillonneur (75) et l'entrée du dispositif de saisie.

## Claims

1. Test device for electronic equipment (4) comprising a device (1) for generating analog test signals intended for the equipment to be tested, a digital computer (9) coupled to a digital-analog conversion device (6) and to means (5) for storing test signals in the form of digital samples, a device (2) for detecting the signals furnished by the electronic equipment tested in response to the test signals received by the equipment, as well as visual presentation means (3) controlled by the computer for visual presentation of the signals transmitted by the test signal generating means and/or the signals received by the detection means, the digital computer (9) comprising means (18, 10, 20, 21) for generating test signals in the form of digital samples and means (8) for transferring the samples stored in the storage means and the samples generated by the generating means to the digital/analog conversion means, characterized in that the means for generating the test signals in the form of samples are constituted by a microprogrammed processing unit (18) and are coupled respectively to means (20) for storing test signal descriptors, to means (19, 20) for storing instruction program sequences, to means (19) for storing data for obtaining samples for enabling the addressing of the test signal descriptors to the storage means, and a keyboard (21), and that the means for storing the test signal descriptors comprise for each descriptor a zone (24) indicating the type of the descriptor, a zone (25) for storing the start address of the instruction sequence to obtain the samples corresponding to said descriptor, address zones (26, 27, 28, 28 BIS) for working zones to allocate parameters relating to the signal in the data storage means, and an address zone (26) to identify the start of a zone for allocating the samples in the data storage means.

2. Device according to claim 1, characterized in that the working zone for allocating the parameters comprises :
— a zone (26) for allocating a parameter giving the amplitude of the first sample of the signal,
— a zone (27) for allocating a parameter giving the amplitude of the last sample,

— and a zone (28) for allocating the instant of the generating of the last sample.

3. Device according to any one of claims 1 and 2. characterized in that the device for generating analog test signals includes a read-write memory (8) interposed between the digital/analog conversion device (6) and the storage means (5) as well as means (7) for synchronising the transfer of the samples stored in the read-write memory to the digital/analog conversion device.

4. Device according to claim 3, characterized in that the read-write memory (8) is addressed by an address counter (58) controlled by the computer for writing samples to the read-write memory and controlled by the synchronization means for reading samples out of the read-write memory.

5. Device according to any one of claims 1 to 4, characterized in that it further comprises demultiplexers (46, 47) for writing the samples to the read-write memory and a multiplexer (48) for transferring the samples from the read-write memory to the analog/digital converter.

6. Device according to claim 5, characterized in that the demultiplexers (46, 47) are controlled by the computer.

7. Device according to any one of claims 3 to 6, characterized in that the multiplexer (48) is controlled by the synchronization means.

8. Device according to any one of claims 1 to 7, characterized in that the detection device comprises a generator (62) for generating the current address of the signal arriving at the input of the device, a sampling block (63) for sampling the signals received by the device and a comparator device (64) connected by an input to the output of the generator for current addresses, another input of the comparator device (64) receiving the address of the signal which is to be detected and the output of the comparator furnishing a control signal for the sampling block (63) for enabling it to detect the current signal present at the input of the device when the address of the current signal is equal to the address of the signal which is to be detected.

9. Device according to claim 8, characterized in that the sampling block (63) comprises a sampler (75) and a control device (84) addressed by the generator for current addresses for supplying preprogrammed control signals to the sampler.

10. Device according to claim 9, characterized in that the sampling block (63) comprises a control register (85) for enabling or partially masking the preprogrammed control signals furnished by the control device (84).

11. Device according to claim 9 or 10, characterized in that the sampling block (63) comprises a digital/analog converter (76) connected to the output of the sampler (75).

12. Test apparatus for television sets, characterized in that it comprises a device as claimed in claims 1 to 11.

13. Apparatus according to claim 12, characterized in that the device for detecting television signals coming from the equipment tested comprises a generator (62) for generating current addresses made up of a first counter (69) advancing in the rhythm of the instants of the sampling of the signal of the current television image spot which is present at the input of the detection device to give the address of the current spot in its line within the television image, and a second counter (70) advancing in the rhythm of the line synchronization signals of the television signal to give the address of the line of the current spot.

14. Apparatus according to claims 12 and 13, characterized in that the device for detecting television signals comprises a sampling block (63) having a first register (8) for storing the address of the spot in the line to be sampled and a second register (80) for storing the line address of the spot to be sampled.

15. Apparatus according to any one of claims 12 to 14, characterized in that the sampling block also comprises a first and a second counter (79, 78) programmable to be able to be charged with the contents of the first and second register (81, 80) respectively for storing the spot to be sample.

16. Apparatus according to any one of claims 12 to 15, characterized in that the comparator device (14) of the detection device comprises a first comparator (72) connected by an input to the output of the first counter of the generator for current addresses and connected by a second input to the output of the first programmable counter (79) of the sampling block as well as a second comparator (73) connected by one input to the output of the second counter (70) of the generator for current addresses and connected by a second input to the output of the second programmable counter (73) of the sampling block (63) for detecting identity between the address of the current spot and the address of the desired spot contained in the first and second programmable counters (79, 78) and enabling the control of the sampler (75).

17. Apparatus according to any one of claims 12 to 15, characterized in that the analog/digital converter (76) of the sampling device furnishes at the end of the conversion cycle signals for incrementing by unity the contents of the first and second programmable counters (78, 79).

18. Apparatus according to any one of claims 12 to 17, characterized in that the signals for incrementing the contents of the first and second programmable counters are enabled by the control device (84) of the device for detecting television signals.

19. Apparatus according to any one of claims 12 to 17, characterized in that the sampling block also comprises a network (74) for processing the television signals received, interposed between the sampler (75) and the input of the detection device.

**Patentansprüche**

1. Prüfvorrichtung für elektronische Geräte (4), versehen mit einer Vorrichtung (1) zur Erzeugung von analogen Prüfsignalen, welche für die zu prüfenden Geräte bestimmt sind, mit einem Digitalrechner (9), der an eine Digital/Analog-Umsetzvorrichtung (6) und an Mittel (5) zur Speicherung von Prüfsignalen in Form von digitalen Abtastproben angekoppelt ist, mit einer Vorrichtung (2) zur Erfassung der Signale, welche von den geprüften elektronischen Geräten ansprechend auf die von den Geräten empfangenen Prüfsignale geliefert werden, sowie Mitteln (3) zur Sichtdarstellung, welche durch den Rechner gesteuert werden, um eine sichtbare Darstellung zu liefern von den Signalen, welche von der Prüfsignal-Erzeugungsvorrichtung übertragen werden, und/oder von den Signalen, welche die Erfassungsvorrichtung empfängt, wobei der Digitalrechner (9) Mittel (18, 10, 20, 21) zur Erzeugung von Prüfsignalen in Form von digitalen Abtastproben sowie Mittel (8) zur Überführung der innerhalb der Speichermittel gespeicherten Abtastproben und der durch die Erzeugungsmittel erzeugten Abtastproben zu der Digital/Analog-Umsetzvorrichtung umfaßt, dadurch gekennzeichnet, daß die Mittel zur Erzeugung der Prüfsignale in Form von Abtastproben durch eine mikroprogrammierte Verarbeitungseinheit (18) gebildet sind und jeweils angekoppelt sind an Mittel (20) zur Speicherung von Prüfsignalbeschreibungen, an Mittel (19, 20) zur Speicherung von Instruktionsprogrammsequenzen, an Mittel (19) zur Speicherung von Daten, um Abtastproben zu erhalten, durch welche die Adressierung der Prüfsignalbeschreibungen an die Speichermittel ermöglicht wird, sowie an eine Tastatur (21), und daß die Mittel zur Speicherung der Prüfsignalbeschreibungen für jede Beschreibung eine Zone (24), welche den Typ der Beschreibung angibt, eine Zone (25) zur Speicherung der Anfangsadresse der Instruktionssequenz, um die dieser Beschreibung entsprechenden Abtastproben zu erhalten, Adresszonen (26, 27, 28, 28 BIS) für Arbeitszonen, um das Signal betreffende Parameter in den Daten-Speichermitteln einzuordnen, und eine Adresszone (26) enthalten, um den Beginn einer Zone zur Einordnung der Abtastproben in den Daten-Speichermitteln zu identifizieren.

2. Vorrichtung nach Anspruch 1, dadurch gekennzeichnet, daß die Arbeitszone zum Einordnen der Parameter umfaßt :
— eine Zone (26) zum Einordnen eines Parameters, welcher die Amplitude der ersten Abtastprobe des Signals angibt,
— eine Zone (27), um einen Parameter einzuordnen, welcher die Amplitude der letzten Abtastprobe angibt,
— und eine Zone (28) zum Einordnen des Zeitpunktes der Erzeugung der letzten Abtastprobe.

3. Vorrichtung nach Anspruch 1 oder 2, dadurch gekennzeichnet, daß die Vorrichtung zur Erzeugung von analogen Prüfsignalen einen Lese-Schreib-Speicher (8) umfaßt, welcher zwischen der Digital/Analog-Umsetzvorrichtung (6) und den Speichermitteln (5) angeordnet ist, sowie Mittel (7) umfaßt, um die Überführung der innerhalb des Lese-Schreib-Speichers gespeicherten Abtastproben zur Digital/Analog-Umsetzvorrichtung zu synchronisieren.

4. Vorrichtung nach Anspruch 3, dadurch gekennzeichnet, daß der Lese-Schreib-Speicher (8) durch einen Adresszähler (58) adressiert wird, welcher durch den Rechner gesteuert wird, um Abtastproben in den Lese-Schreib-Speicher einzuschreiben, und durch die Synchronisationsmittel gesteuert wird, um Abtastproben aus dem Lese-Schreib-Speicher auszulesen.

5. Vorrichtung nach einem der Absprüche 1 bis 4, dadurch gekennzeichnet, daß sie ferner Demultiplexer (46, 47) zum Einschreiben der Abtastproben in den Lese-Schreib-Speicher und einen Multiplexer (48) zur Überführung der Abtastproben von dem Lese-Schreib-Speicher zu dem Analog/Digital-Umsetzer umfaßt.

6. Vorrichtung nach Anspruch 5, dadurch gekennzeichnet, daß die Demultiplexer (46, 47) durch den Rechner gesteuert werden.

7. Vorrichtung nach einem der Ansprüche 3 bis 6, dadurch gekennzeichnet, daß der Multiplexer (48) durch die Synchronisationsmittel gesteuert wird.

8. Vorrichtung nach einem der Ansprüche 1 bis 7, dadurch gekennzeichnet, daß die Erfassungsvorrichtung versehen ist mit einem Generator (62) zur Erzeugung der laufenden Adresse des Signals, welches sich am Eingang der Vorrichtung einfindet, mit einem Abtastblock (63) zur Abtastung des von der Vorrichtung empfangenen Signals und mit einer Komparatorvorrichtung (64), welche an einem Eingang mit dem Ausgang des Generators für laufende Adressen verbunden ist, während ein anderer Eingang der Komparatorvorrichtung (64) die Adresse des Signals empfängt, welches erfaßt werden soll, wobei der Ausgang des Komparators ein Steuersignal für den Abtastblock (63) abgibt, um ihn freizugeben, damit er das laufende Signale erfaßt, welches am Eingang der Vorrichtung vorhanden ist, wenn die Adresse des laufenden Signals gleich der Adresse des Signals ist, das erfaßt werden soll.

9. Vorrichtung nach Anspruch 8, dadurch gekennzeichnet, daß der Abtastblock (63) einen Abtaster (75) und eine Steuervorrichtung (84) umfaßt, welche durch den Generator für laufende Adressen adressiert wird, um vorprogrammierte Steuersignale dem Abtaster zuzuführen.

10. Vorrichtung nach Anspruch 9, dadurch gekennzeichnet, daß der Abtastblock (63) ein Steuerregister (85) umfaßt, um die vorprogrammierten, durch die Steuervorrichtung (84) abgegebenen Steuersignale freizugeben oder teilweise zu maskieren.

11. Vorrichtung nach Anspruch 9 oder 10, dadurch gekennzeichnet, daß der Abtastblock (63) einen Digital/Analog-Umsetzer (76) umfaßt, der mit dem Ausgang des Abtasters (75) verbunden ist.

12. Prüfapparat für Fernsehgeräte, dadurch gekennzeichnet, daß er eine Vorrichtung umfaßt, wie sie in den Ansprüchen 1 bis 11 beansprucht wird.

13. Apparat nach Anspruch 12, dadurch gekennzeichnet, daß die Vorrichtung zur Erfassung von Fernsehsignalen, welche aus den geprüften Geräten stammen, einen Generator (62) zur Erzeugung von laufenden Adressen umfaßt, der zusammengesetzt ist aus einem ersten Zähler (69), der im Rhythmus der Zeitpunkte der Abtastung des Signals des laufenden Fernsehbildpunktes, das am Eingang der Erfassungsvorrichtung vorhanden ist, weiterzählt, um die Adresse des laufenden Punktes in seiner Zeile innerhalb des Fernsehbildes anzugeben, und aus einem zweiten Zähler (70), der im Rhythmus der Zeilensynchronisationssignale des Fernsehsignals fortzählt, um die Adresse der Zeile des laufenden Punktes anzugeben.

14. Apparat nach den Ansprüchen 12 und 13, dadurch gekennzeichnet, daß die Vorrichtung zur Erfassung von Fernsehsignalen einen Abtastblock (63) umfaßt, der ein erstes Register (81) zur Speicherung der Adresse des Punktes in der abzutastenden Zeile und ein zweites Register (80) zur Speicherung der Zeilenadresse des abzutastenden Punktes enthält.

15. Apparat nach einem der Ansprüche 12 bis 14, dadurch gekennzeichnet, daß der Abtastblock ferner einen ersten sowie einen zweiten Zähler (79, 78) umfaßt, die derart programmierbar sind, daß sie mit dem Inhalt des ersten bzw. des zweiten Registers (81, 80) zur Speicherung des abzutastenden Punktes geladen werden können.

16. Apparat nach einem der Ansprüche 12 bis 15, dadurch gekennzeichnet, daß die Komparatorvorrichtung (64) der Erfassungsvorrichtung einen ersten Komparator (72) umfaßt, welcher an einem Eingang mit dem Ausgang der ersten Zählers des Generators für laufende Adressen verbunden ist und an einem zweiten Eingang mit dem Ausgang des ersten programmierbaren Zählers (79) des Abtastblockes verbunden ist, sowie einen zweiten Komparator (73) umfaßt, der an einem Eingang mit dem Ausgang des zweiten Zählers (70) des Generators für laufende Adressen verbunden ist und an einem zweiten Eingang mit dem Ausgang des zweiten programmierbaren Zählers (73) des Abtastblockes (63) verbunden ist, um eine Gleichheit zwischen der Adresse des laufenden Punktes und der Adresse des gewünschten Punktes zu erfassen, welche in dem ersten und in dem zweiten programmierbaren Zähler (79, 78) enthalten ist, und die Steuerung des Abtasters (75) freizugeben.

17. Apparat nach einem der Ansprüche 12 bis 15, dadurch gekennzeichnet, daß der Analog/Digital-Umsetzer (76) der Abtastvorrichtung am Ende des Umsetzzyklus Signale liefert, um den Inhalt des ersten und des zweiten programmierbaren Zählers (78, 79) um eine Einheit hochzuschalten.

18. Apparat nach einem der Ansprüche 12 bis 17, dadurch gekennzeichnet, daß die Signale zum Hochschalten des Inhalts des ersten und des zweiten programmierbaren Zählers durch die Steuervorrichtung (84) der Vorrichtung zur Erfassung von Fernsehsignalen freigegeben werden.

19. Apparat nach einem der Ansprüche 12 bis 17, dadurch gekennzeichnet, daß der Abtastblock ferner ein Netzwerk (74) zur Verarbeitung der empfangenen Fernsehsignale enthält, das zwischen den Abtaster (75) und den Eingang der Erfassungsvorrichtung eingefügt ist.

Fig.1

Fig.2

Fig.3

Fig.4

Fig.5

# Fig.6

0 089 873

**0 089 873**

Fig.7

Fig.9

Fig.8

COMPTEUR V

| ROM | 109 | 84 |

| MASQUE | 111 | → SAC |

| REGISTRE | 110 |

Fig. 10

AUTORISATION D'ÉCHANTILLONNAGE

| ET | 113 | 82 |

COMP H

| OU | 112 |

COMP V    SAC

Fig. 11

Fig.12

Fig. 14

Fig. 13